# EUROPEAN PATENT APPLICATION

(11) **EP 1 482 772 A2**
(43) Date of publication of application: **01.12.2004**
(21) Application number: 04253159.0
(22) Date of filing: 28.05.2004
(51) Int. Cl.: H05K 3/40, H05K 3/46

(54) **Wiring substrate, process for manufacturing the wiring substrate, and carrier sheet for green sheet used in the manufacturing process**

(30) Priority: 29.05.2003 JP 2003153116; 05.09.2003 JP 2003313511; 07.01.2004 JP 2004001869
(71) Applicant: NGK SPARK PLUG CO., LTD, Mizuho-ku Nagoya-shi Aichi (JP)
(72) Inventor: Katagiri, Hiroshi c/o NGK Spark Plug Co., Ltd., Nagoya-shi Aichi (JP); Kambe, Rokuro c/o NGK Spark Plug Co., Ltd., Nagoya-shi Aichi (JP); Sato, Manabu c/o NGK Spark Plug Co., Ltd., Nagoya-shi Aichi (JP); Koike, Kazumasa c/o NGK Spark Plug Co., Ltd., Nagoya-shi Aichi (JP); Seto, Masaharu c/o NGK Spark Plug Co., Ltd., Nagoya-shi Aichi (JP); Suganuma, Takatoshi c/o NGK Spark Plug Co., Ltd., Nagoya-shi Aichi (JP); Mizoguchi, Akira c/o NGK Spark Plug Co., Ltd., Nagoya-shi Aichi (JP)
(74) Representative: Brown, Kenneth Richard

(57) **Abstract**

A carrier sheet for green sheet having a green sheet forming face on which a green sheet is to be formed, comprising: metal foil; and a resin film stacked on a first surface of said metal foil on a side of said green sheet forming face having a smaller thickness than that of said metal foil.

## Description

### FIELD OF THE INVENTION

The present invention relates to a wiring substrate made of ceramics, a process for manufacturing the wiring substrate, and a carrier sheet for green sheet to be used in the manufacturing process.

### BACKGROUND OF THE INVENTION

When a wiring substrate having a multi-layered structure made of ceramics is to be manufactured, fine via holes are formed in a green sheet to make the ceramics, so that via conductors for providing conductions between an upper wiring layer and a lower wiring layer may be formed in the green sheet.

As this via hole forming method, there has been provided (as referred to JP-A-61-74792 (pages 1 to 3, Fig. 3), for example) a method for irradiating a green sheet, which is formed over a carrier sheet including either metal foil such as copper foil or aluminum foil or a polyethylene terephthalate (as will be called the "PET" hereinafter) film, with a carbon dioxide gas laser or YAG laser beam.

According to the aforementioned method, however, in case the carrier sheet is composed of only the metal foil, this metal foil is deformed with a weak impact and does not restore its original mode once it is deformed. Therefore, the green sheet is easily dispersed in its thickness when it is formed over such carrier sheet.

In case the carrier sheet is composed of the PET film, on the other hand, the via holes are formed deeply in the inside of the carrier sheet. Therefore, the via conductors to be formed later have excessive protrusions thereby to cause a problem that they may deteriorate the flatness of the adjoining green sheet.

On the other hand, there has also been proposed a method (as referred to JP-A-2002-314252 (pages 1 to 11, Fig. 1), for example) for forming through-holes for via holes only in a green sheet arranged to cover a metal film pattern, by arranging the metal film pattern over a carrier sheet made of a resin and by irradiating the green sheet with a laser beam.

According to this method, however, the method (including deposition → application of a photoresist → exposure → etching → chemical plating) for arranging the metal film pattern over the carrier sheet of the resin is complicated. Even if the metal film pattern can be arranged, it is so extremely thin that it cannot reflect the laser beam sufficiently but may be damaged of itself. Moreover, the reflected light of the laser beam is so unstable as to raise a problem that the light damages the carrier sheet of the resin.

### SUMMARY OF THE INVENTION

The present invention has an object to solve the problems thus far described in the background thereof and to provide a wiring substrate including insulating layers having a high flatness and made of ceramics, and a process for manufacturing the wiring substrate, a carrier sheet for green sheet adapted to be used in the manufacturing process and capable of forming via holes precisely and reliably only in green sheets.

In order to solve the above-specified problems, the invention has been conceived by using a carrier sheet of a composite structure, in which metal foil and a resin film are stacked.

According to a first aspect of the invention, specifically, there is provided a carrier sheet for green sheet characterized by having a green sheet forming face on which a green sheet is to be formed, and comprising: metal foil; and a resin film stacked on a first surface of the metal foil on a side of the green sheet forming face and having a smaller thickness than that of the metal foil.

According to this aspect, the metal foil stacking the resin film is hardly deformed so that the green sheet can be formed flat on the surface of the resin film, as will be described hereinafter. When this green sheet is irradiated with a laser beam, moreover, it is possible to reliably form the via hole, which extends through the green sheet and the resin film. At the same time, the adjoining metal foil reflects the laser beam so that the initial state can be held. Moreover, the protrusion of the via conductor formed later in the via hole can be suppressed within the thickness of the resin film when the carrier sheet is released. Therefore, the structure can contribute to an effective manufacture of the wiring substrate of ceramics, which is obtained by stacking a plurality of green sheets and which has the via conductor precisely therein. Here, the metal foil and the resin film are stacked through an extremely thin adhesive, for example.

In addition, the invention can cover a carrier sheet for green sheet, which includes metal foil having a thickness of 3 to 200 µm, and a resin film stacked on the metal foil and having a smaller thickness of 2 to 30 µm than that of the metal foil.

The metal foil is exemplified by copper foil having a thickness of 3 to 140 µm or aluminum foil having a thickness of 5.5 to 200 µm, and the resin film is exemplified by a resin film of PET or the like having a thickness of 2 to 30 µm. Here, the aluminum foil includes foil of an aluminum alloy, and the copper foil includes foil of a copper alloy.

The metal foil is easily damaged or deformed, if its thickness is less than 3 µm, and is degraded in its thickness precision if its thickness exceeds 200 µm. Therefore, it is desired the metal foil has the above-specified range.

The deformation suppressing effect by the adj oining metal foil easily lowers, if the resin film has a thickness less than 2 µm, and the thickness precision degrades if the thickness of the resin film exceeds 30 µm. Therefore, it is desired that the resin film has the above-specified range.

Moreover, the invention covers, as a preferable embodiment, a carrier sheet for green sheet, in which a releaser layer is formed on the green sheet forming face of the resin film.

According to this structure, when the carrier sheet is to be released after the via hole and the via conductor were formed in the green sheet, the resin film having the via conductor extended partially therethrough can be easily released together with the metal foil from the green sheet.

Here, the releaser layer is exemplified by a thin Si-coated layer.

Moreover, the invention also covers, as a preferable embodiment, a carrier sheet for green sheet, in which a low-friction sheet (or a deformation preventing sheet) having a lower coefficient of friction than that of the metal foil is stacked on a second surface of the metal foil on the opposite side of the first surface.

In addition, the invention covers, as a preferable embodiment, a carrier sheet for green sheet having a green sheet forming face on which a green sheet is to be formed, which comprises: metal foil; and a low-friction sheet (or a deformation preventing sheet) stacked on the surface of the metal foil on an opposite side of the green sheet forming face, and having a lower coefficient of friction than that of the metal foil.

According to these structures, when a ceramic material is slid on a drying section while being cast to a constant thickness over the green sheet forming face of the resin film or the metal foil in the carrier sheet thereby to form the green sheet, it is possible to reduce the friction between the carrier sheet and the drying section. As a result, the sliding speed of the carrier sheet can be stabilized to a constant value so that the thickness precision of the green sheet obtained can be enhanced. Moreover, when the carrier sheet is to be released after the via hole and the via conductor were formed in the green sheet, the carrier sheet can be prevented from being deformed, so that it can be repeatedly used.

Here, the low-friction sheet (or the deformation preventing sheet) may be exemplified by a film of a resin such as PET, a film of silicone, silane, cloth, paper or rubber, and may also be exemplified by highly elastic metal foil of a kind different from that of the metal foil of the carrier sheet, and its thickness is not especially limited. Moreover, the low-friction sheet is desired to have a coefficient of friction of 3 or less (excepting 0). The coefficient of friction was measured according to JIS P 8147. Specifically, the friction coefficient measuring device used was DR-2 of Toyo Seimitsu Seisakusho KK. The measurement was performed by adhering a specimen (having a size of 80 mm x 200 mm) to a base made of a glass plate by means of tape, by placing a block (or weight) of stainless steel of 1 Kg on the specimen, by connecting the block to the load cell of a constant-speed elongation pulling tester, and by moving the block at a speed of 100 mm/min. and over a distance of 100 mm.

According to another aspect of the invention, there is provided a wiring substrate manufacturing process characterized by comprising in the following order: a step of forming a green sheet over the green sheet forming face of the resin film in the carrier sheet for green sheet; a step of forming a through-hole penetrating through the green by irradiating the green sheet in the thickness direction with a laser beam; a step of forming a via conductor by filling the through-hole with a conductive material; and a step of removing the carrier sheet for green sheet from the green sheet. At the step of forming the through-hole in the green sheet, a bottomed hole is preferably formed in the resin film by a laser beam wherein the bottomed hole preferably has a depth of 30 µm or less. And, at the via conductor forming step, the conductive material is preferably filled both in the through-hole but also the bottomed hole.

According to this aspect, there can be reliably and easily manufactured in the green sheet the wiring substrate which has the via hole penetrating through the green sheet and the via conductor formed in the via hole and having a small protrusion from the surface of the green sheet. In the mode of the aspect, in which the bottomed via hole is filled with the conductive material, it is possible to reliably prevent the filling conductive material from sticking to the metal foil and the formed via conductor from coming out at the step of removing the carrier sheet.

In addition, the invention can cover a wiring substrate manufacturing process further comprising such a step between the step of forming the via conductor and the step of removing the carrier sheet as stacks and thermally contact-bonding a new green sheet on the green sheet with the carrier sheet for green sheet.

In this case, it is possible to reliably manufacture the wiring substrate of ceramics, which is obtained by stacking a plurality of green sheets and which has the via conductor precisely therein.

Here, the new green sheet covers the unit, in which the carrier sheet is symmetrically attached in advance to the opposite side of the carrier sheet.

Moreover, the invention covers, as a preferable embodiment, a wiring substrate manufacturing process, in which after the step of removing the carrier sheet for green sheet, the protrusion of the via conductor protruding from the surface of the green sheet is 30 µm or less.

According to this process, when a new green sheet is stacked on and thermally contact-bonded to the surface of the green sheet, the flatness of the new green sheet is not degraded, and the conduction can be reliably retained between the via conductor and the adjoining via conductor or the wiring layer.

Here, if the protrusion of the via conductor exceeds 30 µm, the flatness of the green sheet may be degraded to induce an inter-layer shorting, for example. Therefore, the protrusion is set to 30 µm or less, and the desirable protrusion is 10 µm or less.

In addition, the invention can cover a wiring substrate manufacturing process, which further comprises, after the aforementioned individual steps, the step of stacking and thermally contact-bonding a plurality of green sheets having the via conductors, and the step of calcining the stack of the green sheets obtained.

In this case, it is possible to reliably manufacture the wiring substrate made of ceramics including the via conductor and having a multi-layered structure.

In addition, according to another aspect of the invention, there is provided a wiring substrate comprising: an upper insulating layer having an upper via conductor; an upper wiring layer; an intermediate insulating layer; a lower wiring layer; and a lower insulating layer having a lower via conductor arranged substantially concentric along an axial direction with said upper via conductor, provided in this order, wherein a ratio t1/t2 of a thickness t1 of said intermediate insulating layer at a position, in which said intermediate insulating layer is sandwiched between said upper and lower via conductors and between said upper and lower wiring layers, to a thickness t2 of said intermediate insulating layer at a position, in which said via conductors are not located in said upper and lower insulating layers and in which said intermediate insulating layer is sandwiched between said wiring layers, is set to not less than 0.72 but less than 1.0.

According to this structure, it is possible to reduce the protrusion (i.e., the displacement distance in the thickness direction) of the via conductor into the adjoining insulating layer of ceramics or the wiring layer formed on the surface of the insulating layer. Therefore, it is possible to prevent formation of the clearances between the adjoining insulating layers, careless short-circuiting (or shorting) of the wiring layers positioned between the insulating layers, and excessive deformation of the patterns of the wiring layers. Thus, it is possible to provide a wiring substrate of a multi-layer structure having a high flatness and an excellent precision, which includes the three or more insulating layers and the via conductors penetrating through the insulating layer.

Here, the range of the ratio less than 0.72 is excluded because at least one of the formation of the clearances, the short-circuiting and the pattern deformation of the wiring layers. In the mode where the flat conductive layers are formed all over the three insulating layers, moreover, the ratio of the distance between the upper and lower wiring layers at positions, where the wiring layers are sandwiched between the paired upper and lower via conductors penetrating through the upper and lower insulating layers and narrowed by the protrusions of the via conductors, to the distance between the upper and lower wiring layers atpositions, where the paired via conductors do not exist, is also 0.72 or more and less than 1.0. Moreover, the upper, intermediate and lower insulating layers are the relative names in the substrate body having the three or more insulating layers stacked.

In addition, the invention can cover a wiring substrate manufacturing process or a wiring substrate manufactured by the process, in which the aforementioned ratio of t1/t2 is 0.72 or more and less than 1.0, in case: the green sheet and the insulating layer obtained by calcining the former has a thickness of 15 to 45 µm; the metal foil in the carrier sheet has a thickness of 30 µm; and the resin film has a thickness of 4 to 15 µm.

### BRIEF DESCRIPTION OF THE DRAWINGS

Fig. 1 is a sectional view showing a first carrier sheet of the invention;
Fig. 2 is a sectional view showing an applied mode of the carrier sheet;
Fig. 3 is a schematic diagram showing a step in a wiring substrate manufacturing process of the invention using the carrier sheet of Fig. 1;
Fig. 4 is a schematic diagram showing a step subsequent to Fig. 3;
Fig. 5 is a schematic diagram showing a step subsequent to Fig. 4;
Fig. 6 is a schematic diagram showing a step subsequent to Fig. 5;
Fig. 7 is a schematic diagram showing a step subsequent to Fig. 6;
Fig. 8 is a schematic diagram showing a step subsequent to Fig. 7;
Fig. 9 is a schematic diagram showing a step subsequent to Fig. 8;
Fig. 10 is a schematic diagram showing a step subsequent to Fig. 9;
Fig. 11 is a schematic diagram showing a step subsequent to Fig. 10;
Fig. 12 is a schematic diagram showing a step subsequent to Fig. 11;
Fig. 13 is a schematic diagram showing a step subsequent to Fig. 12;
Fig. 14 is a schematic section showing a wiring substrate of the invention obtained by the manufacturing process;
Fig. 15 is a sectional view showing a carrier sheet of another mode;
Fig. 16 is a schematic diagram showing a step in another wiring substrate manufacturing process of the invention using the carrier sheet;
Fig. 17 is a schematic diagram showing a step subsequent to Fig. 16;
Fig. 18 is a schematic diagram showing a step subsequent to Fig. 17;
Fig. 19 is a schematic diagram showing a step subsequent to Fig. 18;
Fig. 20 is a schematic section showing a wiring substrate of another mode in the invention;
Fig. 21 is an enlarged diagram of a portion X enclosed by single-dotted lines in Fig. 20;
Fig. 22 is a diagram showing distributions of the ratio in the wiring substrates of Examples and Comparisons;
Fig. 23 is a similar diagram on the wiring substrates of different Examples and Comparisons;
Fig. 24 is a similar diagram on the wiring substrates of other Examples and Comparisons;
Fig. 25 is a schematic view showing a green sheet manufacturing process using the carrier sheet of the invention; and
Fig. 26 is an enlarged diagram of a portion Y enclosed by single-dotted lines in Fig. 25.

### [DESCRIPTION OF REFERENCE NUMERALS AND SIGNS]

- 1, 1a, 1b: CARRIER SHEET
- 2: ALUMINUM FOIL (METAL FOIL)
- 3a: BACK (SURFACE ON THE SIDE TO HAVE NO GREEN SHEET SHAPED)
- 4: PET FILM (RESIN FILM)
- 5: GREEN SHEET FORMING FACE
- 6, 6a to 6e: GREEN SHEET
- 7: LOW-FRICTION SHEET
- 8a to 8e: VIA HOLE (THROUGH-HOLE)
- 8f: VIA HOLE (BOTTOMED HOLE)
- 10: CONDUCTIVE MATERIAL
- 12, 16, 20, 24, 28: VIA CONDUCTOR
- K, K': WIRING SUBSTRATE
- h: SUBSTRATE BODY
- L: CARBON DIOXIDE GAS LASER (LASER)
- r: RELEASER LAYER
- s1 to s3: INSULATING LAYER
- t: PROTRUSION OF VIA CONDUCTOR
- t1: THICKNESS OF INSULATING LAYER SANDWICHED BETWEEN UPPER AND LOWER VIA CONDUCTORS AND BETWEEN WIRING LAYERS
- t2: THICKNESS OF INSULATING LAYER SANDWICHED ONLY BETWEEN UPPER AND LOWER WIRING LAYERS

### DETAILED DESCRIPTION OF THE INVENTION

The best mode for carrying out the invention will be described with reference to the accompanying drawings.

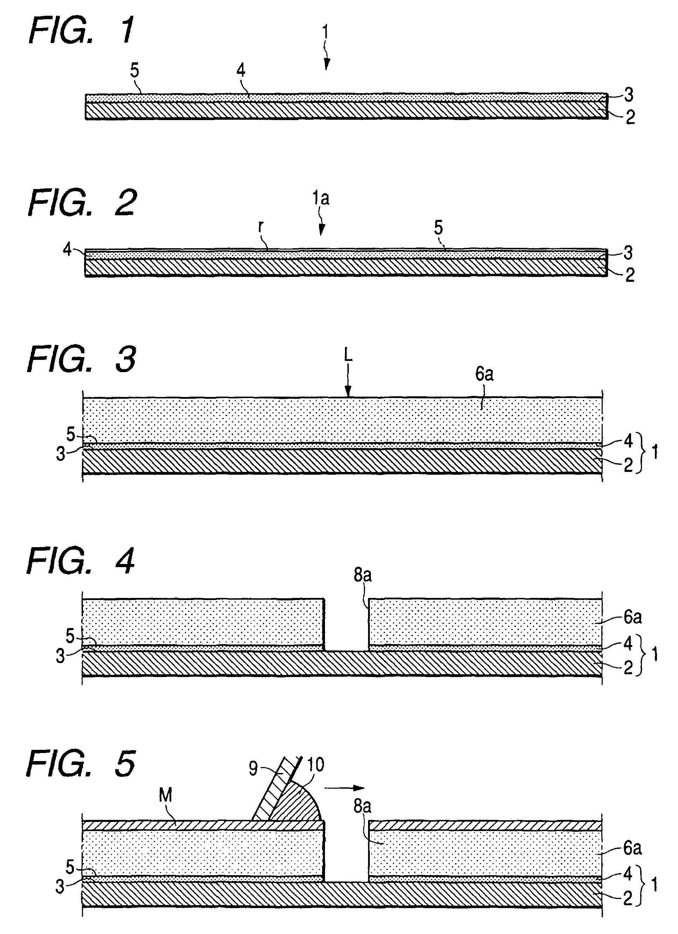

Fig. 1 is a sectional view showing a first carrier sheet for green sheet 1 in the invention. Fig. 2 is a sectional view showing a carrier sheet for green sheet 1a in an applied mode.

As shown in Fig. 1, the carrier sheet 1 is provided with aluminum foil (or metallic foil) 2 having a thickness of 40 µm, and a PET film (or a resin film) 4 having a thickness of 4 µm and stacked on the surface 3 of the aluminum foil 2 through a not-shown adhesive layer. The surface of the PET film 4 is a green sheet forming face 5 for shaping a later-described green sheet thereon.

As shown in Fig. 2, too, the carrier sheet for green sheet 1a is provided with the aluminum foil 2 and the PET film 4 having thicknesses like the aforementioned ones. A releaser layer r of a thin Si-coated layer is formed all over the surface (5) of the PET film 4. In this carrier sheet 1a, the green sheet is formed on the surface of that releaser layer r.

The carrier sheet for green sheets 1 and 1a thus far described are advantageous in that they can be obtained merely by applying the aluminum foil 2 and the PET film 4 to each other and in that they are tough and hardly deformable. Moreover, a laser beam pass, when emitted, through the PET film 4 and the releaser layer r, but is reflected by the thicker aluminum foil 2. Thus, the carrier sheet 1 or 1a can be prevented from being damaged by the laser beam.

Here will be described a process for manufacturing a wiring substrate using the carrier sheet 1. In the following, the carrier sheet for green sheet 1 will be shortly called the "carrier sheet 1".

First of all, a green sheet 6a having a thickness of about 120 µm is formed by a later-described method over the green sheet forming face 5 of the PET film 4 in the carrier sheet 1, as shown in Fig. 3, by applying and solidifying ceramic slurry composed mainly of alumina and borosilicate glass into a sheet shape with a doctor blade.

Next, the green sheet 6a is irradiated at a predetermined position, as indicated by arrow in Fig. 3, with a carbon dioxide gas laser beam (or a laser beam) L along its thickness direction. This laser beam L is emitted under conditions: a vibration energy of 10 micro-joules; a vibration interval of 30 micro-seconds; a shot number of 1 time; and a mask diameter of 2.0 mm.

As a result, in the trace irradiated with the laser beam L, as shown in Fig. 4, there is formed a via hole (or a through-hole) 8a substantially of a circular column shape, which extends through the green sheet 6a and the PET film 4 of the carrier sheet 1. The via hole 8a thus formed has an internal diameter of about 170 micro-meters, and the surface 3 of the aluminum foil 2 of the carrier sheet 1 is exposed to the bottom face of the via hole 8a.

Next, a squeezee 9 is slid along a metal mask M having a thickness of about 30 µm and arranged on the surface of the green sheet 6a, as shown in Fig. 5, to print/fill a pasty conductive material 10 containing Ag powder or the like in the via hole 8a.

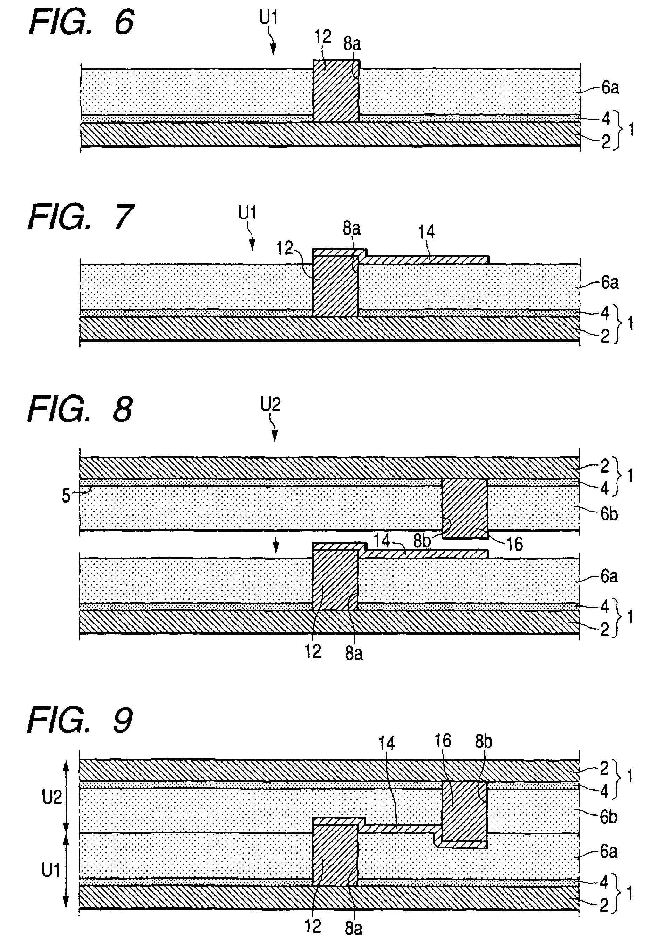

As a result, there is formed in the via hole 8a a following via conductor 12, as shown in Fig. 6. At the same time, there is also formed a unit U1, which is provided with the carrier sheet 1, the green sheet 6a and the via conductor 12. Here, the via conductor 12 has its upper end protruded by the thickness of the metal mask M from the surface of the green sheet 6a.

Moreover, a not-shown metal mask having a predetermined pattern forming hole is arranged just above the via conductor 12 and on the surface of the green sheet 6a, and the conductive material 10 is printed like before. As a result, a wiring layer 14 to follow that pattern and to be connected with the via conductor 12 is formed on the surface of the green sheet 6a, as shown in Fig. 7. Here, the wiring layer 14 may also be formed by the aforementioned printing operation simultaneously with the filling of the via conductor 12.

On the unit U1 having the wiring layer 14, as shown in Figs. 8 and 9, there is stacked and thermally contact-bonded another unit U2, which is formed in advance like before. As shown in Fig. 8, the unit U2 is provided with the carrier sheet 1, a green sheet 6b formed like before on the green sheet forming face 5 of the PET film 4, and a via conductor 16 formed by the aforementioned laser treatment in a via hole 8b penetrating at a predetermined position through the PET film 4 and the green sheet 6b. Here, the carrier sheet 1 may also be replaced by the aforementioned carrier sheet 1a having the releaser layer r.

The unit U2 is stacked, as indicated by an arrow in Fig. 8, on the unit U1 arranged on a not-shown flat base face such that its green sheet 6b confronts the green sheet 6a of the unit U1, and the carrier sheet 1 of the unit U2 is pushed downward. As a result, the units U1 and U2 are stacked, as shown in Fig. 9, and their via conductors 12 and 16 are connected with each other through the wiring layer 14. This wiring layer 14 is displaced along the thickness direction in accordance with the protrusions of the via conductors 12 and 16, as shown in Fig. 9.

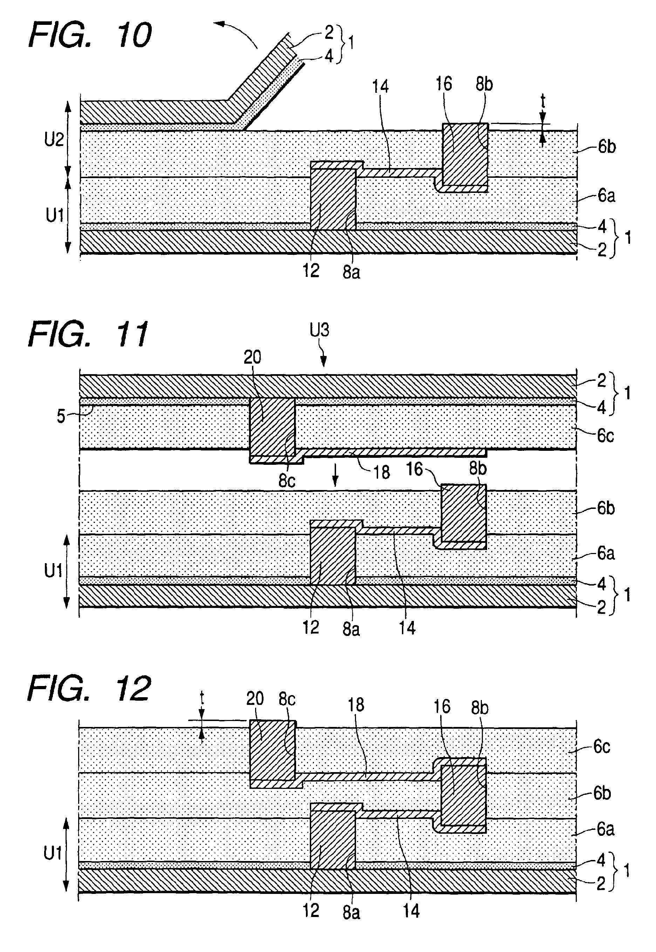

Next, the carrier sheet 1 positioned over the green sheet 6b is released sequentially from its righthand end to the lefthand end, as indicated by an arrow in Fig. 10. At this time, the upper end of the via conductor 16 is so protruded by a protrusion t of 4 µm from the surface of the green sheet 6b as accords to the thickness of the PET film 4 in the carrier sheet 1 removed, as shown in Fig. 10. Here, the aforementioned release is facilitated if the aforementioned carrier sheet 1a having the releaser layer r is used in place of the carrier sheet 1.

Moreover, a unitU3 formed separately in advance is stacked and thermally contact-bonded on the surface of the green sheet 6b and the via conductor 16, as indicated by an arrow in Fig. 11.

That unit U3 is provided with the carrier sheet 1, and a green sheet 6c formed like before over the green sheet forming face 5 of the PET film 4 of the carrier sheet 1, as shown in Fig. 11. Moreover, a via conductor 20 is formed in a via hole 8c penetrating at a predetermined position through the PET film 4 and the green sheet 6c by the aforementioned laser treatment, and a wiring layer 18 is formed like before on the surface of the green sheet 6c.

Next, the carrier sheet 1 of the unit U3 is removed like before. Then, the green sheets 6b and 6c are stacked on the green sheet 6a of the unit U1, as shown in Fig. 12. At the same time, the upper end of the via conductor 20 is protruded by the same protrusion t as the aforementioned one from the surface of the green sheet 6c. Here, the via conductors 16 and 20 are connected through the wiring layer 18 simultaneously with the stacking operation. Moreover, the wiring layer 18 is displaced in the thickness direction by the protrusion at the upper end of the via conductor 16 and by the protrusion at the lower end of the via conductor 20.

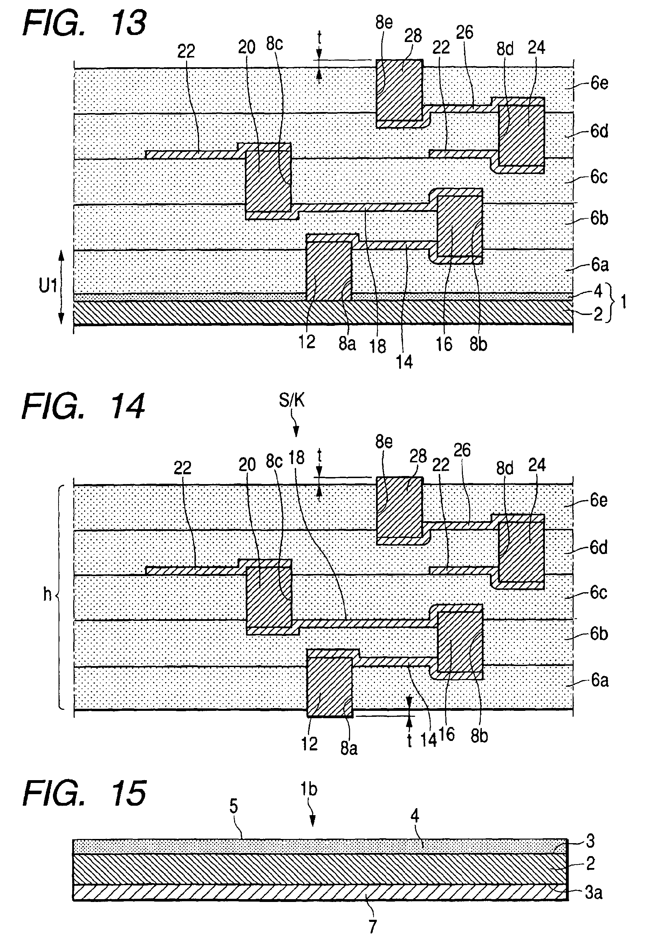

Next, a new unit, which is provided, as shown in Fig. 13, with: a green sheet 6d; a via conductor 24 formed in the via hole 8d of the green sheet 6d; a wiring layer 22 formed on the surface of the green sheet 6d; and the carrier sheet 1, is stacked like before on the surface of the green sheet 6c. After this, the carrier sheet 1 of that new unit is removed.

Here, the aforementioned carrier sheet 1a having the releaser layer r can be easily released, if it is used in place of the carrier sheet 1.

As shown in the upper portion of Fig. 13, moreover, another new unit, which is provided with : a green sheet 6e; a via conductor 28 formed in the via hole 8e of the green sheet 6e; a wiring layer 26 formed on the surface of the green sheet 6e; and the carrier sheet 1, is stacked like before on the surface of the green sheet 6d. After this, the carrier sheet 1 of that new unit is removed.

As a result, the upper end of the via conductor 28 is protruded by the same protrusion t as the aforementioned one from the surface of the green sheet 6e, and the via conductors 24 and 28 are connected through the wiring layer 26 simultaneously with the stacking/contact-bonding operation through the wiring layer 26.

Here, the wiring layer 22 is displaced in the thickness direction by the protrusion at the upper end of the via conductor 20 and by the protrusion at the lower end of the via conductor 24. The wiring layer 26 is displaced in the thickness direction by the protrusion at the upper end of the via conductor 24 and by the protrusion at the lower end of the via conductor 28.

Then, the carrier sheet 1 of the unit U1 positioned in the lowermost layer is removed.

As a result, there is formed a stacked structure S, which is provided with the green sheets 6a to 6e, the wiring layers 14, 18, 22 and 26 of predetermined patterns positioned between those green sheets 6a to 6e, and the via conductors 12, 16, 20, 24 and 28 connecting those wiring layers 14, 18, 22 and 26, as shown in Fig. 14. Here, the lower end of the via conductor 12 is protruded by the same protrusion t as the aforementioned one from the back (as located on the lower side) of the lowermost green sheet 6a.

In the stacked structure S thus made and at the via conductor 28 protruding from the green sheet 6e of the uppermost layer, there is formed the (not-shown) well-known connection terminal, which is to be connected with an IC chip or the like to be mounted over the via conductor 28. At the lower end of the via conductor 12 of the green sheet 6a of the lowermost layer, there is formed the (not-shown) well-known connection terminal, which is to be connected with a mother board.

By calcining the stacked structure within a necessary temperature range and for a necessary time period, there is obtained a wiring substrate K, which is provided with: a substrate body h having five stacked insulating layers of ceramics calcined from the green sheets 6a to 6e; the wiring layers 14 and 18 sintered between the insulating layers; and the via conductors 12 and 16 and so on.

According to the process thus far described for manufacturing the wiring substrate K by using the carrier sheet 1, it is possible to reliably and easily manufacture the wiring substrate K, which is provided, in the green sheets 6a to 6e, with: the via holes 8a to 8e extended through those the green sheets 6a to 6e; and the via conductors 12 and 28 and so on formed in those via holes 8a to 8e and protruded by the protrusion t of 4 µm or less from the surfaces of the green sheet 6a to 6e. Moreover, the carrier sheets 1 (or 1a) are hardly deformed so that the flatness of the green sheets 6a to 6e formed on the green sheet forming faces 5 of the carrier sheets can be easily retained. Even with the irradiation of the laser beam L, moreover, the via holes 8a to 8e can be formed exclusively in the thin PET films 4, and the protrusions t of the via conductors 12, 28 and so on to be formed in the via holes can be shortened to 30 µm or less.

In the wiring substrate K, on the other hand, the protrusion (or the displacement distance in the thickness direction) of the via conductors 12 and 16 and so on into either the adjoining insulating layers of ceramics or the wiring layer 1 and so on formed on the surfaces of those insulating layers can be reduced to 4 µm or less. Therefore, it is possible to prevent formation of the clearances between the adjoining insulating layers, careless short-circuiting (or shorting) of the wiring layers positioned between the insulating layers, and excessive deformation of the patterns of the wiring layers.

Fig. 15 is a sectional view showing a carrier sheet for green sheet 1b in a mode different from those of the aforementioned carrier sheets 1 and 1a.

As shown in Fig. 15, the carrier sheet 1b is provided with: aluminum foil (or metallic foil) 2 having a thickness like that of the aforementioned carrier sheets; a PET film (or a resin film) 4 having a thickness of 4 µm and stacked on the surface 3 of the aluminum foil 2 through the not-shown adhesive layer; and a PET film 7 (or a low-friction sheet: a deformation preventing sheet) having a thickness of 4 µm and formed like before on such a back 3a (or the surface of the side, on which no green sheet is formed) of the aluminum foil 2 as is located on the opposite side of the PET film 4. The surface of the PET film 4 provides the green sheet forming face 5, on which the green sheet is to be formed. Here, the PET film 7 has such a coefficient of friction at about 1.3 according to the aforementioned measuring method as is lower than that of about 6 of the aluminum foil (or the metal foil) or the later-described drying section.

According to this carrier sheet for green sheet 1b, in addition to the functions/effects of the foregoing carrier sheet 1 (1a), the carrier sheet 1b can be prevented, when released after the via hole and the via conductor were formed in the green sheet, from being deformed, so that it can be repeatedly used. Moreover, the friction with the drying section to be used at the step of manufacturing the green sheet itself is lowered, as will be specified hereinafter. The speed of the carrier sheet 1b to slide on the surface of the drying section can be stabilized at a constant value thereby to enhance the thickness precision of the green sheet.

Here, the residual of the carrier sheet 1b, from which the PET film (or the resin film) 4 has been removed, is the second carrier sheet for green sheet in the invention.

Here will be described a wiring substrate manufacturing process in the mode, which is made different from the foregoing one by using the aforementioned carrier sheet for green sheet 1b (as will be called the "carrier sheet 1b").

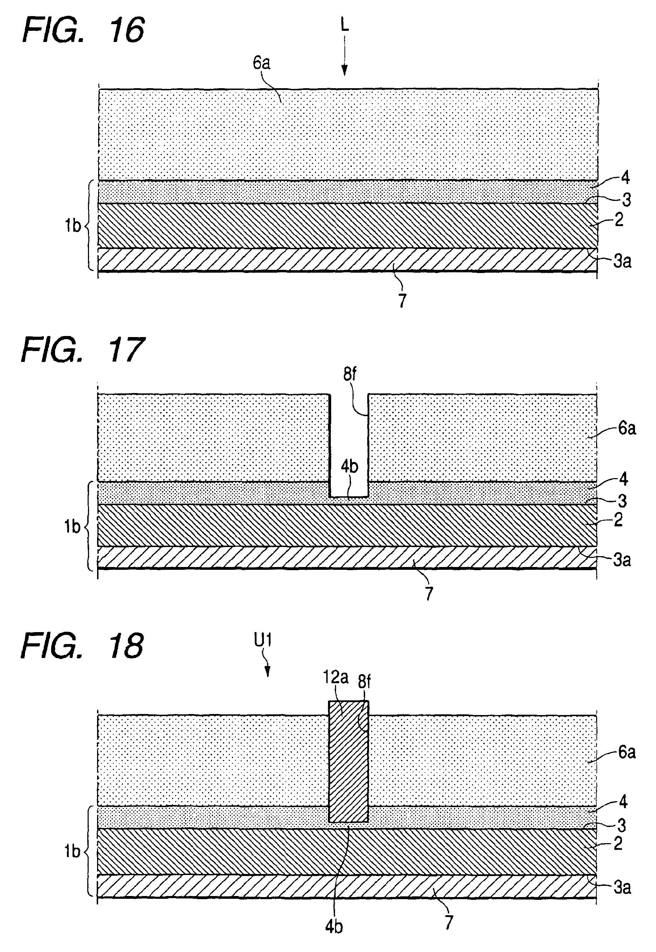

First of all, the green sheet 6a having a thickness of about 120 µm is formed over the green sheet forming face 5 of the PET film 4 in the carrier sheet 1b, as shown in Fig. 16, by applying and solidifying ceramic slurry composed mainly of alumina and borosilicate glass into a sheet shape with a doctor blade.

Next, the green sheet 6a is irradiated at a predetermined position, as indicated by arrow in Fig. 16, with the carbon dioxide gas laser beam (or the laser beam) L along its thickness direction. This laser beam L is emitted under conditions: a vibration energy of 5 micro-joules; a vibration interval of 50 micro-seconds; a shot number of 4 times; and a mask diameter of 2.4 mm.

As a result, in the trace irradiated with the laser beam L, as shown in Fig. 17, there is formed a via hole (or a bottomed hole) 8f substantially of a circular column shape, which extends through the PET film 4 of the carrier sheet 1b while leaving a portion 4b (having a thickness of about 1 micron) close to the aluminum foil 2. The via hole 8f thus formed has an internal diameter of about 200 micro-meters, and the surface 3 of the aluminum foil 2 of the carrier sheet 1 is close to the bottom face of the via hole 8f. Moreover, the squeezee 9 is slid along the metal mask M arranged like before on the surface of the green sheet 6a to print/fill the pasty conductive material 10 containing Ag powder or the like in the via hole 8f.

As a result, there is formed in the via hole 8a a following via conductor 12a, as shown in Fig. 18, thereby to form the unit U1, which is provided with the carrier sheet 1b, the green sheet 6a and the via conductor 12a. Here, the via conductor 12a also has its upper end protruded by the thickness of the metal mask M from the surface of the green sheet 6a.

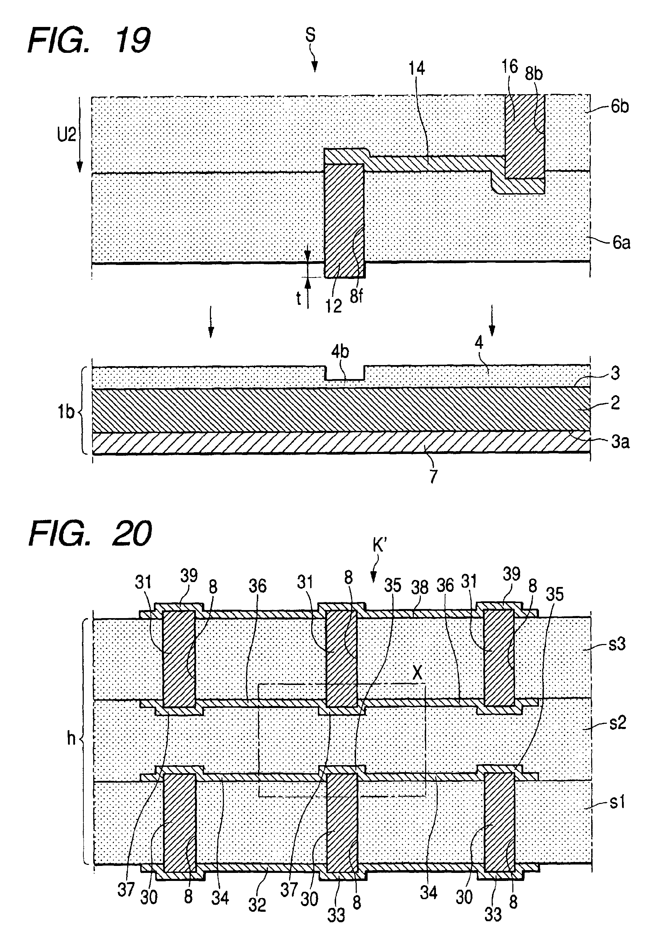

Next, the metal mask having a predetermined pattern forming hole is arranged just above the via conductor 12a and on the surface of the green sheet 6a, and the conductive material 10 is printed like before. As a result, the wiring layer 14 to be connected with the via conductor 12a is formed on the surface of the green sheet 6a, as shown in the upper portion of Fig. 19. Here, the wiring layer 14 may also be formed at the aforementioned printing time simultaneously with the filling of the via conductor 12a.

Next, over the unit U1 having the wiring layer 14, like before, there is stacked and thermally contact-bonded the unit U2, which is separately formed in advance like before. As a result, the units U1 and U2 are stacked, as shown in the upper portion of Fig. 19, and their via conductors 12a and 16 are connected through the wiring layer 14.

Moreover, another unit is stacked like before on the unit U2, and the carrier sheet 1b of a unit Un of the uppermost layer is then released like before. At this time, the via conductor penetrating through the green sheet of that unit Un is protruded by the protrusion t of about 3 µm from the surface of that green sheet.

As indicated by arrows in Fig. 19, moreover, there is removed the carrier sheet 1b of the unit U1, which is positioned in the lowermost layer. As a result, the lower end of the via conductor 12a is protruded by the protrusion t of about 3 µm from the back (as located on the lower side of Fig. 19) of the green sheet 6a. At this time, the leading end portion of the via conductor 12a is spaced from the aluminum foil 2 by the portion 4b of the PET film 4, so that the leading end portion neither sticks to the aluminum foil 2 nor comes out when the carrier sheet 1b is removed.

As a result, there can be formed a stacked structure (S), which is provided like before with the green sheets 6a and 6b to 6e, the wiring layers 14 and so on of predetermined patterns positioned between those green sheets 6a to 6e, and the via conductors 12 and 16 so on connecting those wiring layers, as shown in Fig. 14. The wiring substrate K like before can be obtained by calcining that stacked structure.

Here, the carrier sheet 1b may be replaced by the aforementioned carrier sheet 1 or the aforementioned carrier sheet 1a having the releaser layer r.

Fig. 20 presents a partial section of a wiring substrate K', which is obtained by each of the aforementioned manufacturing processes.

As shown in Fig. 20, the wiring substrate K' is provided with a substrate body h, which is manufactured by stacking three insulating layers s1, s2 and s3 calcined from the green sheets 6a to 6c. In the upper insulating layer s1 and the lower insulating layer s3, respectively, there are formed at the same positions, as seen in the stacking direction: the via holes 8 and 8 having an internal diameter of about 100 µm; and a plurality of via conductors 30 and 31 penetrating in and through the insulating layers s1 and s3 and protruded by 4 µm or 3 µm from the two surfaces of the insulating layers s1 and s3.

On the two surfaces of the upper insulating layer s1 and the lower insulating layer s3, moreover, there are formed flat wiring layers (or conductive layers) 32, 34, 36 and 38, which cover the upper and lower ends of the via conductors 30 and 31. These wiring layers 32, 34, 36 and 38 have an average thickness of 15 µm and are provided with disc-shaped protrusions 33, 35, 37 and 39, which are displayed along the thickness direction of the substrate body h by the protrusions at the upper/lower ends of the via conductors 30 and 31.

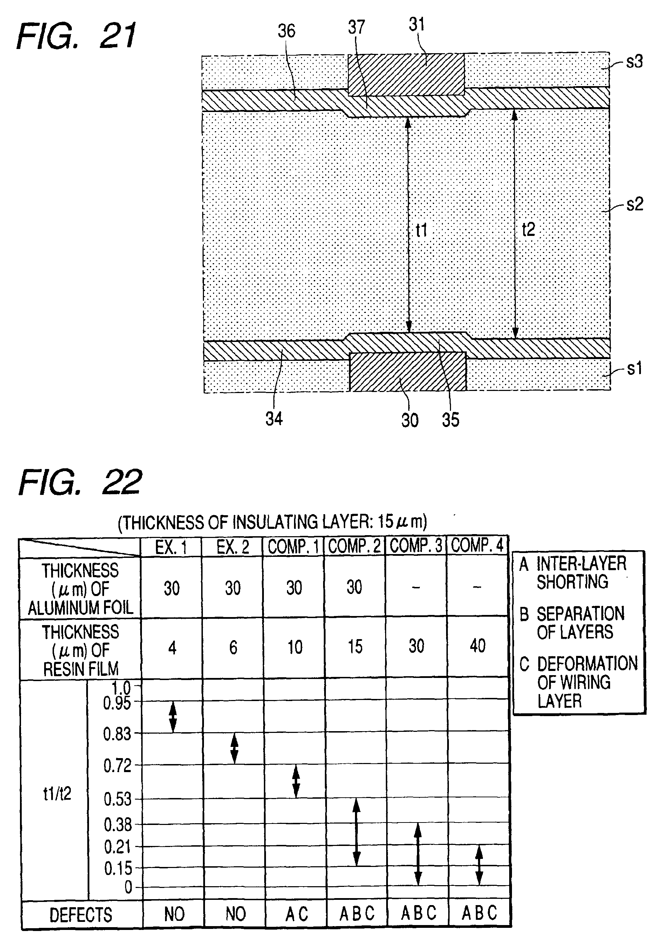

In the intermediate insulating layer s2, as shown in Fig. 21 enlarging a portion X enclosed by single-dotted lines in Fig. 20, the wiring layers (or the conductive layers) 34 and 36 are positioned between the adjoining insulating layers s1 and s2, and the portions of the insulating layer s2 sandwiched between the protrusions 35 and 37 underlaid and overlaid by the via conductors 30 and 31 are made slightly thinner than the remaining portions. These thinner portions are the displacement (or the distance), which is made by the protrusions of the via conductors 30 and 31.

In Fig. 21, the ratio t1/t2 of the thickness t1 of the insulating layer s2, as sandwiched between the protrusions 35 and 37 and between the wiring layers 34 and 36, to the thickness t2 of the insulating layer s2, as sandwiched not between the protrusions 35 and 37 but between the wiring layers 34 and 36, is set to not less than 0.72 but less than 1.0.

### EXAMPLES

Here will be described Specific Examples of the wiring substrate K'.

Twelve wiring substrates K' of the structure thus far described were manufactured by the aforementioned manufacturing process using the carrier sheet 1b and changing the thicknesses of the insulating layers s1 to s3. Moreover, six wiring substrates of the aforementioned structure were manufactured by the similar manufacturing process using the carrier sheet of the prior art made exclusively of the PET film and by changing the thicknesses of the insulating layers s1 to s3.

The twelve wiring substrates K' were manufactured by changing the thickness of the PET film (or the resin film) 4 while keeping the aluminum foil 2 of the carrier sheet 1b at a constant thickness of 30 µm.

On the totally eighteen wiring substrates (K'), individually, the ratio t1/t2 of the thickness t1 of the insulating layer s2, as sandwiched between the protrusions 35 and 37 and between the wiring layers 34 and 36, to the thickness t2 of the insulating layer s2, as sandwiched not between the protrusions 35 and 37 but between the wiring layers 34 and 36, was measured at twenty portions.

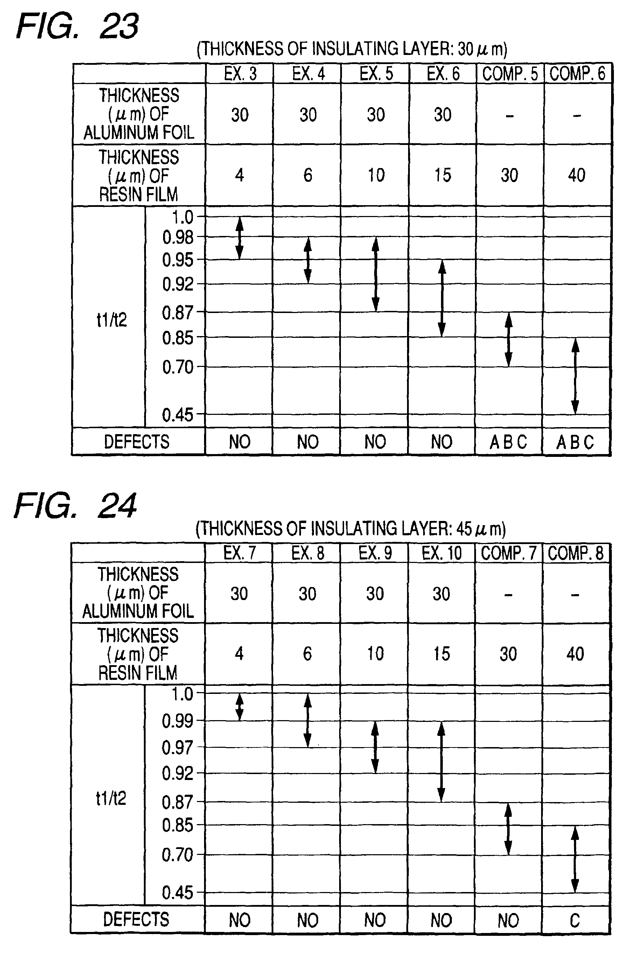

The distribution ranges of the ratio of t1/t2 of the six wiring substrates (K') having the insulating layers s1 to s3 of the thickness of 15 µm were individually indicated by vertical thick arrows in Fig. 22; the distribution ranges of the ratio of t1/t2 of the six wiring substrates (K') having the insulating layers s1 to s3 of the thickness of 30 µm were indicated in Fig. 23; and the distribution ranges of the ratio of t1/t2 of the six wiring substrates (K') having the insulating layers s1 to s3 of the thickness of 45 µm were indicated in Fig. 24.

On all the wiring substrates (K'), moreover, it was examined whether or not there were: the short-circuiting (i.e., the inter-layer shorting: a defect A) between the wiring layers 34 and 36; the clearance between the insulating layers s1 to s3 (i.e., the in-layer separation: a defect B) ; and an excessive deformation of 10 µm or more of the wiring layers 34 and 36 (i.e., the deformation of the wiring layers: a defect C). In case at least one defect existed in the wiring layers, it was indicated as the defects A to C in Figs. 22 to 24.

According to the diagram of Fig. 22, the wiring substrates K' of Examples 1 and 2 had the aforementioned ratio of t1/t2 within the range of 0.72 to 0.95 and had no defect. On the contrary, the wiring substrates of Comparisons 1 to 4 had the defects A and C, or the defects A to C.

According to the diagram of Fig. 23, moreover, the wiring substrates K' of Examples 3 to 6 had the aforementioned ratio of t1/t2 within the range of 0.85 to 1.0 and had no defect. On the contrary, the wiring substrates of Comparisons 5 and 6 individually had the defects A to C.

According to the diagram of Fig. 24, still moreover, the wiring substrates K' of Examples 7 to 10 had the aforementioned ratio of t1/t2 within the range of 0.87 to 1.0 and had no defect. On the contrary, the wiring substrates of Comparison 8 had the defect C.

Here, the distribution range of the aforementioned ratio of t1/t2 rose closer to 1.0, and the defects A to C reduced. This is because the insulating layers s1 to s3 had thicknesses increased sequentially to 15 µm, 30 µm and 45 µm.

From the results indicated in the aforementioned diagrams of Fig. 22 to Fig. 24, it has been found out that the wiring substrates K' of the invention having the ratio of t1/t2 of not less than 0.72 and less than 1.0 had the flat insulating layers s1 to s3 and such excellent qualities stable as had none of the defects including the shorting between the wiring layers 34 and 36, the separation in the layers and the deformation of the wiring layers 34 and 36. In addition, the effects of the invention were revealed by the results of Fig. 22 to Fig. 24.

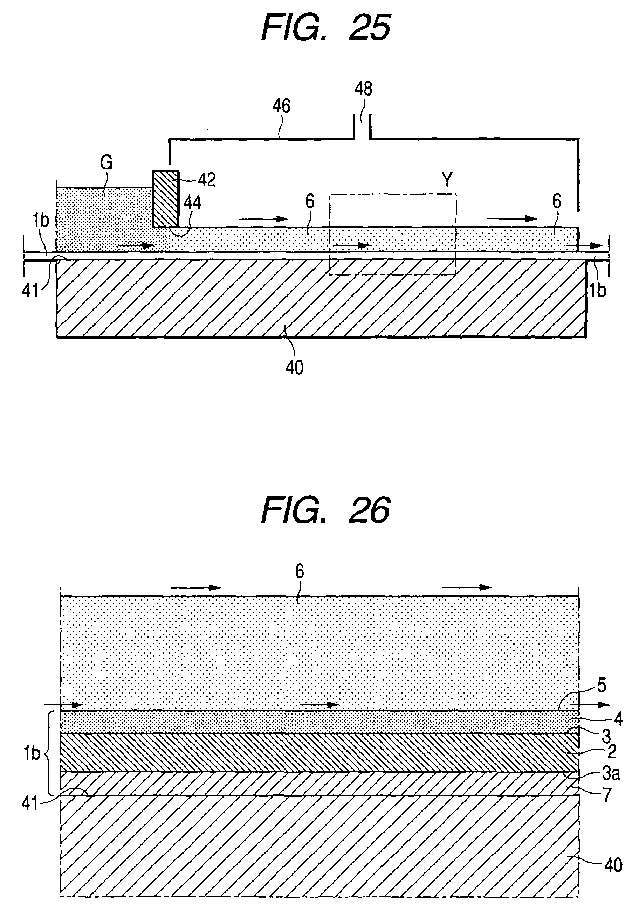

Fig. 25 schematically shows a process for manufacturing a green sheet 6 using the carrier sheet 1b. This carrier sheet 1b is turned back from one side of the not-shown lefthand roller and is conveyed to the righthand side, as indicated by arrows in Fig. 25, while sliding on the surface 41 of a drying section 40. After this, the carrier sheet 1b is taken up together with the green sheet 6 obtained, by the righthand roller.

The drying section 40 is made of stainless steel or an aluminum alloy having a coefficient of friction of about 6, for example, and has a plurality of hot water baths (although not shown) therein. On the lefthand side of Fig. 25 and over the drying section 40, there is reserved ceramic slurry G, which is composed mainly of alumina and borosilicate glass. The ceramic slurry G is discharged (or cast) in the shape of a sheet having an average thickness of about 120 µm from an opening 44 in the lower side of a weir 42 onto the green sheet forming face 5 of the carrier sheet 1b. Here, a hood 4 6 having a discharge port 48 is arranged over the drying section 40, as shown in Fig. 25.

As shown in Fig. 2 6 presenting an enlargedportion enclosed by single-dotted lines of Fig. 25, the green sheet 6 having a thickness of 120 µm is dried while being moved to the right over and in synchronism with the green sheet forming face 5 of the carrier sheet 1b sliding over the surface 41 of the drying section 40.

The carrier sheet 1b is moved at a stabilized constant speed, because the low-friction sheet 7 having a coefficient of friction of 3 or less slides on the surface 41 of the drying section 40 having a coefficient of friction of about 6. As a result, the green sheet 6 has its thickness precision improved to have a homogeneous composition so that it is also stabilized in a high quality.

Here, the green sheet 6 thus obtained is once taken up in a coil shape on the roller and is turned back and cut to a predetermined size. As a result, the aforementioned green sheets 6a to 63 are obtained and are calcined to form the aforementioned insulating layers s1 to s3.

The invention should not be limited to the embodiments thus far described.

For example, the metal foil of the carrier sheet for green sheet includes not only the aluminum foil but also copper foil and stainless steel foil. Moreover, this metal foil may also be formed by depositing or chemically plating the surface of the resin film with the metal.

On the other hand, the material of the resin film of the carrier sheet includes not only the aforementioned PET but also PPS (polyphenylene sulfide), PEN (polyethylene naphthalate) and PI (polyimide).

Moreover, the green sheet may also be composed mainly of not only the aforementioned alumina or borosilicate glass but also aluminum nitride (AlN), mullite or glass-ceramics.

On the other hand, the laser for forming the through-hole or the bottomed via hole may be exemplified not only by the aforementioned carbon dioxide gas laser but also by a YAG laser, an excimer laser or a semiconductor laser.

In the foregoing embodiment, moreover, the carrier sheet is released from the stacked unit Un. However, the green sheet may also be released in advance from the unit Un and stacked.

This application is based on Japanese Patent application JP 2003-153116, filed May 29, 2003, Japanese Patent application JP 2003-313511, filed September 5, 2003, and Japanese Patent application JP 2004-1869, filed January 7, 2004, the entire contents of which are hereby incorporated by reference, the same as if set forth at length.

## Claims

1. A carrier sheet for green sheet having a green sheet forming face on which a green sheet is to be formed, comprising:
metal foil; and
a resin film stacked on a first surface of said metal foil on a side of said green sheet forming face and having a smaller thickness than that of said metal foil.

2. The carrier sheet for green sheet according to claim 1, further comprising a releaser layer so that said metal foil, said resin film and said releaser layer are in this order.

3. The carrier sheet for green sheet according to claim 1, further comprising a low-friction sheet having a lower coefficient of friction than that of said metal foil, said low-friction sheet being stacked on a second surface of said metal foil on an opposite side of said first surface thereof.

4. A carrier sheet for green sheet having a green sheet forming face on which a green sheet is to be formed comprising:
metal foil; and
a low-friction sheet stacked on a surface of said metal foil on an opposite side of said green sheet forming face, and having a lower coefficient of friction than that of said metal foil.

5. A wiring substrate manufacturing process using a carrier sheet for green sheet having a green sheet forming face on which a green sheet is to be formed, said carrier sheet for green sheet comprising metal foil, and a resin film stacked on a first surface of said metal foil on a side of said green sheet forming face and having a smaller thickness than that of said metal foil, said process
comprising, in the following order:
a step of forming a green sheet on said green sheet forming face;
a step of forming a through-hole penetrating through said green sheet by irradiating said green sheet in a thickness direction with a laser beam;
a step of forming a via conductor by filling said through-hole with a conductive material; and
a step of removing said carrier sheet for green sheet from said green sheet.

6. The wiring substrate manufacturing process according to claim 5, wherein at the step of forming said through-hole in said green sheet, a bottomed hole is formed in said resin film by a laser beam.

7. The wiring substrate manufacturing process according to claim 6, wherein said bottomed hole has a depth of 30 µm or less.

8. The wiring substrate manufacturing process according to claim 6, wherein at said via conductor forming step, said conductive material is filled both in said through-hole but also said bottomed hole.

9. The wiring substrate manufacturing process according to claim 5, wherein after the step of removing said carrier sheet for green sheet, a protrusion of said via conductor protruding from a surface of said green sheet is 30 µm or less.

10. A wiring substrate comprising: an upper insulating layer having an upper via conductor; an upper wiring layer; an intermediate insulating layer; a lower wiring layer; and a lower insulating layer having a lower via conductor arranged substantially concentric along an axial direction with said upper via conductor, provided in this order,
wherein a ratio t1/t2 of a thickness t1 of said intermediate insulating layer at a position, in which said intermediate insulating layer is sandwiched between said upper and lower via conductors and between said upper and lower wiring layers, to a thickness t2 of said intermediate insulating layer at a position, in which said via conductors are not located in said upper and lower insulating layers and in which said intermediate insulating layer is sandwiched between said wiring layers, is set to not less than 0.72 but less than 1.0.
